# DEMANDE DE BREVET EUROPEEN

(11) **EP 2 280 411 A2**
(43) Date de publication de la demande: **02.02.2011**
(21) Numéro de dépôt: 10166909.1
(22) Date de dépôt: 22.06.2010
(51) Int. Cl.: H01L 21/68

(54) **Procédé de détermination d'une position centrée d'un substrat semi-conducteur dans un four de recuit, dispositif pour traiter thermiquement des substrats semi-conducteurs et procédé pour calibrer un tel dispositif.**

(30) Priorité: 27.07.2009 FR 0955236
(71) Demandeur: S.O.I. Tec Silicon on Insulator Technologies, 38190 Bernin (FR)
(72) Inventeur: Angellier, Cedric, 38570, Le Cheylas (FR); Palmer, William, 38190, Brignoud (FR)
(74) Mandataire: Collin, Jérôme

(57) **Abrégé**

Procédé de détermination d'une position centrée d'un substrat semi-conducteur disposé dans un four de recuit (30), dans une position de départ, sur un support (20) de maintien dans le four, comprenant les étapes suivantes :
- traitement thermique du substrat dans sa position de départ, aboutissant à la formation d'une couche d'oxyde (11) sur le substrat,
- mesure d'épaisseur du substrat en plusieurs points de la surface oxydée du substrat,
- détermination, à partir de l'étape de mesure et de la position de départ, d'une position centrée du substrat sur le support (20).

Procédé de calibrage d'un dispositif (100) pour traiter thermiquement des substrats semi-conducteurs, le dispositif (100) comprenant des moyens de positionnement (40) de substrats semi-conducteurs sur un support (20) de maintien dans un four (30), les moyens de positionnement (40) comprenant une unité (42) de mémoire destinée à stocker des paramètres (PP) de positionnement et un actionneur (41) apte à positionner un substrat sur le support (20) en fonction de paramètres (PP) de positionnement stockés dans l'unité (42) de mémoire, comprenant les étapes suivantes :
- positionnement par l'actionneur (41) d'un substrat test (T) sur le support (20) dans une position de départ en fonction de paramètres (PP1) de départ prédéterminés,
- application des étapes du procédé de détermination d'une position centrée au substrat test (T),
- détermination de paramètres (PP2) de centrage correspondant à la position centrée du substrat test (T), et
- stockage des paramètres (PP2) de centrage dans l'unité de mémoire (42).

## Description

### DOMAINE TECHNIQUE GENERAL

La présente invention concerne le traitement thermique de substrats semi-conducteurs.

Plus précisément, elle concerne le positionnement de substrats semi-conducteur sur un support de maintien dans un four en vue d'un traitement thermique.

### PROBLEME TECHNIQUE

Il peut être nécessaire d'appliquer un traitement thermique à un substrat semi-conducteur, par exemple pour renforcer sa solidité ou diminuer des défauts de structure induits par un procédé de production.

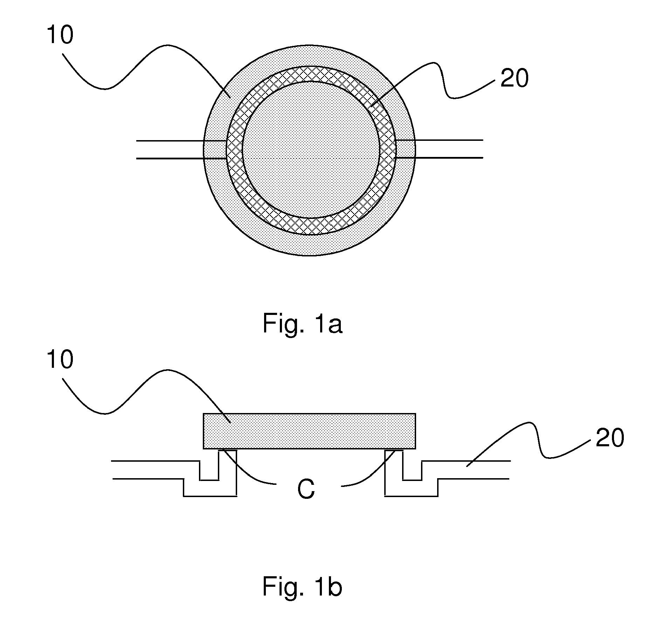

Il est fait référence aux figures 1a et 1b. Dans certains fours, un substrat semi-conducteur 10 de forme circulaire est posé horizontalement sur un support 20 de maintien annulaire comme représenté en vue de dessous sur la figure 1a et en vue de face en coupe sur la figure 1 b.

Lors d'un traitement thermique, de la chaleur du substrat 1 est dissipée dans le support 20 annulaire au niveau de la zone C de contact, représentée quadrillée sur la figure 1a.

Si le substrat est excentré par rapport au support annulaire, cette dissipation est asymétrique, les gradients thermiques résultant provoquant des défauts de structure dans le substrat, par exemple de type lignes de glissement ou « slip lines » en terminologie anglo-saxonne.

Il est donc préférable de centrer autant que faire se peut le substrat sur le support annulaire avant le début du traitement thermique.

### ART ANTERIEUR

Il existe des méthodes pour déterminer qualitativement si le substrat est centré par rapport au support.

On peut par exemple faire tourner le substrat sur un support en rotation par rapport à son centre, et évaluer optiquement le centrage à partir de la forme décrite par le substrat en rotation.

Cette méthode permet de déterminer si le substrat est mal placé, mais ne donne pas d'indication quantitative sur le décalage nécessaire pour positionner le substrat au centre du support. Il faut alors déplacer le substrat par tâtonnements pour obtenir la position centrée voulue.

Cette méthode est donc coûteuse en temps et peu précise.

Il existe par ailleurs une méthode pour évaluer quantitativement le décalage du substrat par rapport au support.

Cette méthode comprend une étape d'implantation d'espèces susceptibles de migrer à haute température (par exemple du bore ou du phosphore) en une position déterminée à la surface du substrat.

On applique ensuite un traitement thermique au substrat, puis on évalue la migration des espèces par mesure de résistance électrique.

La migration des espèces donne une information quantitative sur la symétrie de température au cours du traitement thermique, indicatrice du centrage du substrat sur le support. Il est alors possible de centrer le substrat sur la base de cette information quantitative.

Toutefois, l'implantation d'espèces dans le substrat est une étape lourde à mettre en oeuvre et nécessite un autre équipement spécifique

### PRESENTATION DE L'INVENTION

L'invention propose de pallier à cet inconvénient, et propose un procédé simple pour centrer un substrat sur un support annulaire.

A cet effet, l'invention propose selon un premier aspect un procédé de détermination d'une position centrée d'un substrat semi-conducteur disposé dans un four de recuit, dans une position de départ, sur un support de maintien dans le four, le procédé comprenant les étapes suivantes :
- traitement thermique du substrat dans sa position de départ, le traitement aboutissant à la formation d'une couche d'oxyde sur le substrat,
- mesure d'épaisseur du substrat en plusieurs points de la surface oxydée du substrat, la position des points de mesure sur le substrat étant connue,
- détermination, à partir de l'étape de mesure et de la position de départ, d'une position centrée du substrat sur le support.

L'invention propose, selon un deuxième aspect, un procédé de calibrage d'un dispositif pour traiter thermiquement des substrats semi-conducteurs, le dispositif comprenant des moyens de positionnement de substrats semi-conducteurs sur un support de maintien dans un four, les moyens de positionnement comprenant une unité de mémoire destinée à stocker des paramètres de positionnement et un actionneur apte à positionner un substrat sur le support en fonction de paramètres de positionnement stockés dans l'unité de mémoire, le procédé comprenant les étapes suivantes :
- positionnement par l'actionneur d'un substrat test sur le support dans une position de départ en fonction de paramètres de départ prédéterminés,
- application des étapes du procédé de détermination d'une position centrée selon le premier aspect de l'invention au substrat test,
- détermination de paramètres de centrage correspondant à la position centrée du substrat test, et
- stockage des paramètres de centrage dans l'unité de mémoire..

Le procédé de calibrage selon le deuxième aspect de l'invention est avantageusement itératif, l'ensemble des étapes du procédé étant répétées selon un nombre d'itérations donné, les paramètres de centrage déterminés à chaque itération étant repris comme paramètres de départ de l'itération suivante.

Selon un troisième aspect, l'invention propose un dispositif pour traiter thermiquement des substrats semi-conducteur comprenant :
- un four avec un support de maintien,
- une unité de mesure destinée à déterminer une épaisseur du substrat en plusieurs points de mesure, et
- des moyens de positionnement comprenant
   une unité de mémoire destinée à stocker des paramètres de positionnement correspondant à des positions d'un substrat sur le support,
   un actionneur pour positionner un substrat sur le support en fonction de paramètres de positionnement stockés dans l'unité de mémoire, et
   une unité de traitement destinée à déterminer, en fonction d'une position de départ et de mesures de l'unité de mesure, une position centrée et à déduire de ladite position centrée des paramètres de centrage
   l'unité de mémoire étant en outre destinée à stocker les paramètres de centrage, de sorte à ce que l'actionneur soit apte à positionner des substrats semi-conducteur sur le support dans la position centrée.

L'invention présente de nombreux avantages.

L'invention permet de déterminer, de façon simple, une position centrée d'un substrat sur un support annulaire à partir d'une position de départ et d'un traitement thermique.

L'invention permet en outre de calibrer un dispositif de traitement thermique de substrats, de sorte à diminuer les défauts induits par un décalage des substrats à traiter sur le support annulaire.

### PRESENTATION DES FIGURES

D'autres caractéristiques, buts et avantages de l'invention ressortiront de la description qui suit, qui est purement illustrative et non limitative, et qui doit être lue en regard des dessins annexés sur lesquels :
- les figures 1a et 1b, déjà commentées, représentent schématiquement un substrat sur un support annulaire respectivement en vue de dessous et en vue de face en coupe,
- les figures 2a et 2b représentent schématiquement un substrat sur un support annulaire après traitement thermique selon une réalisation possible des procédés selon les premier et deuxième aspects de l'invention, respectivement en vue de dessous et en vue de face en coupe,
- la figure 2c représente, schématiquement en vue de dessus, des points de mesure de la couche d'oxyde recouvrant un substrat selon une réalisation possible des premier et deuxième aspects de l'invention,
- la figure 3 représente, sous la forme d'un schéma bloc, un procédé de détermination d'une position centrée d'un substrat semi-conducteur selon une réalisation possible du premier aspect de l'invention,
- la figure 4 représente, sous la forme d'un schéma bloc, un procédé de calibrage d'un dispositif pour traiter thermiquement des substrats semi-conducteurs, conformément à une réalisation possible du deuxième aspect de l'invention, et
- la figure 5 représente, sous la forme d'un schéma bloc, un dispositif pour traiter thermiquement des substrats semi-conducteurs selon une réalisation possible du troisième aspect de l'invention,

### DESCRIPTION DETAILLEE

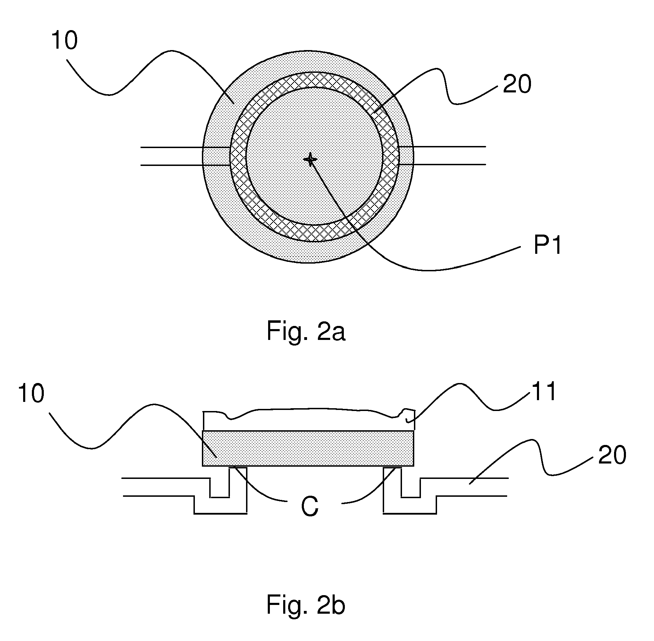

Il est fait référence aux figures 2a et 2b. Le procédé selon le premier aspect l'invention a pour but de déterminer une position centrée d'un substrat semi-conducteur 10 disposé dans un four de recuit sur un support 20 de maintien.

Le substrat est initialement disposé sur le support 20, supposé annulaire, dans une position P1 de départ a priori excentrée par rapport au centre du support 20.

Sur la figure 2a, le substrat 10 a une forme de disque, et sa position P1 est repérée par son centre. L'invention n'est toutefois pas limitée à un substrat en forme de disque, et s'étend plus généralement à toute forme plane de substrat.

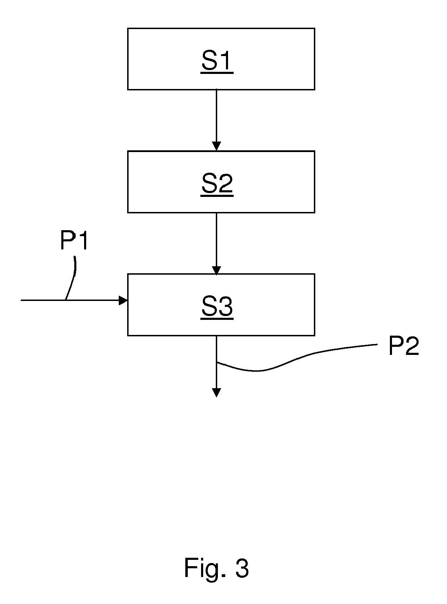

En regard de la figure 3, le procédé selon le premier aspect de l'invention comprend une première étape de traitement thermique S1 du substrat 10 dans sa position P1 de départ.

Ce traitement S1 aboutit à la formation d'une couche d'oxyde 11 sur le substrat 10.

Dans le cadre de l'invention, on entend par couche d'oxyde toute couche susceptible de croitre au cours d'un traitement thermique sur le substrat-semi conducteur, et dont l'épaisseur dépend de la température.

Cette définition n'est pas exclusivement limitée aux oxydes, mais comprend également les nitrures.

Dans la suite, on différencie une surface inférieure du substrat 10, en contact avec le support 20, et une surface supérieure opposée à la surface inférieure. Préférentiellement, la couche d'oxyde 11 est située sur la surface supérieure du substrat 10.

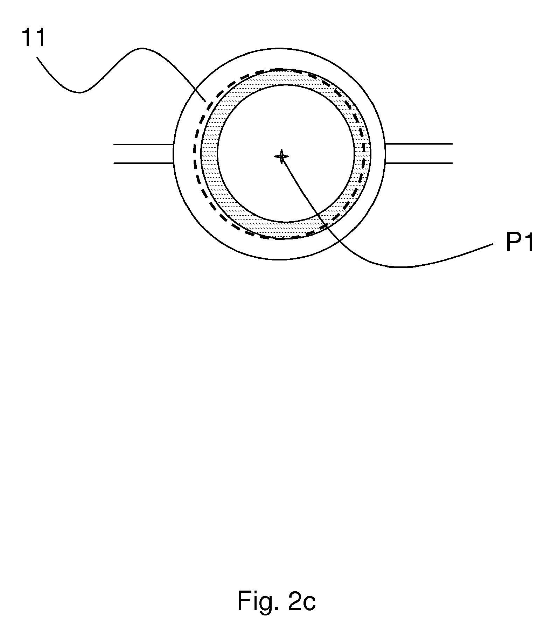

Comme on l'a représenté sur la figure 2b, la couche d'oxyde 11 a une épaisseur qui varie tout particulièrement au niveau correspondant à la zone de contact C entre le substrat 10 et le support 20. La dissipation thermique dans le support 20 ralentit la croissance de la couche d'oxyde 11. Les variations d'épaisseurs de la couche 11 constituent ainsi une empreinte du support 20 en contact avec la surface inférieure du substrat 10. Cette empreinte est représentée en hachures sur la figure 2c (en vue de dessus).

Le procédé selon le premier aspect de l'invention comprend en outre une étape de mesure S2 d'épaisseur du substrat en plusieurs points de la surface oxydée du substrat, c'est-à-dire de la couche 11.

La position de chaque point de mesure par rapport au support 20 est connue et prédéterminée. Par exemple, on a représenté un cercle en pointillés concentrique du support 20, constituant une répartition possible des points de mesure de l'épaisseur de la couche selon le premier aspect de l'invention.

Sur la figure 2c, on constate que ce cercle est situé en partie sur la zone hachurée, dans laquelle l'épaisseur de la couche d'oxyde 11 est plus faible. Aussi, l'épaisseur mesurée sera plus faible à ce niveau, ce qui indiquera que le substrat est excentré par rapport au support.

Bien entendu, les hachures ne sont qu'une illustration schématique de l'empreinte du support annulaire sur la couche d'oxyde 11. En réalité, cette empreinte n'est pas marquée brutalement mais plutôt en dégradé d'épaisseur comme on l'imagine aisément à partir de la figure 2b.

La mesure d'épaisseur peut être effectuée par ellipsométrie, ou par tout autre moyen adapté connu de l'homme de l'art.

Le cercle en pointillés de la figure 2.c est donné à titre d'exemple non limitatif. D'autres configurations de positions de points de mesures sont envisagées dans le cadre de l'invention. En particulier, l'invention couvre les positions de points de mesure déjà exposées par la Demanderesse dans la demande de brevet WO 2006/051243.

Le procédé selon le premier aspect de l'invention comprend aussi une étape de détermination S3, à partir de l'étape de mesure S2 et de la position de départ P1, d'une position centrée P2 du substrat 10 sur le support 20.

Avantageusement, la détermination de la position P2 comprend une détermination préalable d'une direction et d'un sens de décalage à partir de P1, et un calcul d'une longueur de décalage dans la direction et le sens préalablement déterminés.

A titre d'exemple non limitatif, la direction et le sens de décalage à partir de P1 peuvent être déterminés par le vecteur reliant le point où l'épaisseur mesurée est la plus grande et celui où elle est la plus basse.

La longueur de décalage est avantageusement déterminée en fonction de l'épaisseur mesurée en plusieurs points de mesure, préférentiellement l'intégralité des points de mesure, par exemple par comparaison des résultats de la mesure avec un modèle prédéterminé.

Le procédé selon le premier aspect l'invention permet ainsi de déterminer quantitativement le décalage à opérer sur la position de départ P1 pour obtenir une position centrée P2 par rapport au support 20.

Par ailleurs, les étapes de ce procédé peuvent être implémentées pour calibrer un dispositif pour traiter thermiquement des substrats semi-conducteurs.

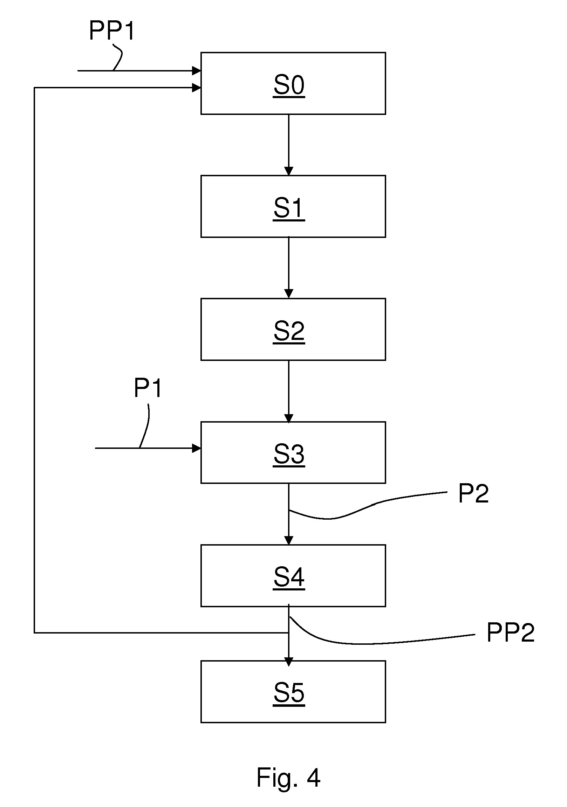

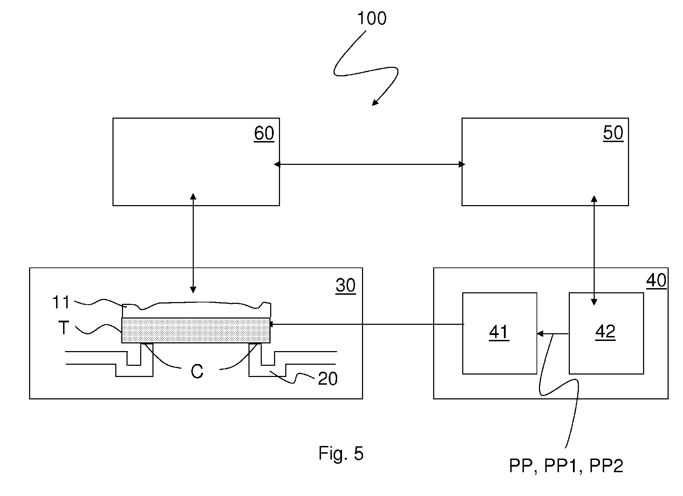

A cet effet, l'invention propose, selon un deuxième aspect, un procédé de calibrage représenté sur la figure 4. Le dispositif destiné à être calibré est un dispositif selon le troisième aspect de l'invention, représenté sous la forme d'un schéma bloc sur la figure 5.

Ce dispositif, référencé 100, comprend des moyens de positionnement 40 de substrats semi-conducteurs 10 sur un support 20 de maintien dans un four 30. Les moyens de positionnement comprennent une unité 42 de mémoire configurée pour stocker des paramètres PP de positionnement et un actionneur 41 apte à positionner un substrat 10 sur le support 20 en fonctions de paramètres PP de positionnement stockés dans l'unité 42 de mémoire.

Le procédé selon le deuxième aspect de l'invention comprend une étape de positionnement S0 d'un substrat test T sur le support 20 dans une position P1 de départ en fonction de paramètres PP1 de départ prédéterminés.

Cette étape est réalisée par l'actionneur 41 du dispositif selon le troisième aspect de l'invention. Les paramètres PP1 sont préalablement stockés dans l'unité 42 de mémoire. Il peut s'agir de paramètres par défaut, de paramètres réglés par un utilisateur, ou, comme on va le voir plus loin dans le cas avantageux d'un procédé itératif, de paramètres déterminés au cours d'une itération précédente.

Le procédé selon le deuxième aspect de l'invention comprend en outre une détermination d'une position centrée P2 par application des étapes du procédé selon le premier aspect de l'invention au substrat test T, ainsi qu'une étape de détermination S4 de paramètres PP2 de centrage correspondant à la position centrée P2.

Les mesures sont réalisées par une unité 60 de mesure du dispositif selon le troisième aspect de l'invention. L'unité 60 transmet les mesures à une unité de traitement 50 du dispositif, configurée pour déterminer, en fonction de la position P1 de départ du substrat test T et des mesures transmises, la position centrée P2 et en déduire les paramètres PP2 de centrage.

Le procédé selon le deuxième aspect de l'invention comprend encore une étape de stockage de ces paramètres PP2 dans l'unité de mémoire 42. Le substrat test T est ensuite retiré du support 20 et évacué du four 30 de recu it.

Les substrats à traiter seront ensuite positionnés dans la position P2 dans le four, qui est ainsi calibré pour un traitement thermique dans lequel les asymétries de température dû à une position excentrée des substrats sur le support 20 sont réduites.

La position P2 ainsi obtenue selon l'invention est centrée à 1/10 de millimètre. Pour une meilleure précision de cette position, on peut appliquer une deuxième fois le procédé selon le deuxième aspect de l'invention avec un nouveau substrat test, en prenant comme position de départ la position de centrage déterminée.

De manière générale, le procédé selon le deuxième aspect de l'invention est avantageusement itératif, les paramètres de départ d'une itération étant les paramètres de centrage déterminés à l'itération précédente. A chaque itération, un nouveau substrat test est utilisé.

Deux itérations du procédé selon le deuxième aspect de l'invention sont suffisantes pour obtenir une précision de l'ordre du centième de millimètre.

## Revendications

1. Procédé de détermination d'une position centrée d'un substrat semi-conducteur (10) disposé dans un four de recuit (30), dans une position (P1) de départ, sur un support (20) de maintien dans le four, **caractérisé en ce qu'**il comprend les étapes suivantes :
- traitement thermique (S1) du substrat (10) dans sa position (P1) de départ, le traitement (S1) aboutissant à la formation d'une couche d'oxyde (11) sur le substrat (10),
- mesure (S2) d'épaisseur du substrat en plusieurs points de la surface oxydée du substrat, la position des points de mesure sur le substrat étant connue,
- détermination (S3), à partir de l'étape de mesure (S2) et de la position de départ (P1), d'une position centrée (P2) du substrat (10) sur le support (20).

2. Procédé de calibrage d'un dispositif (100) pour traiter thermiquement des substrats semi-conducteurs, le dispositif (100) comprenant des moyens de positionnement (40) de substrats semi-conducteurs (10) sur un support (20) de maintien dans un four (30), les moyens de positionnement (40) comprenant une unité (42) de mémoire destinée à stocker des paramètres (PP) de positionnement et un actionneur (41) apte à positionner un substrat (10) sur le support (20) en fonction de paramètres (PP) de positionnement stockés dans l'unité (42) de mémoire, le procédé étant **caractérisé en ce qu'**il comprend les étapes suivantes :
- positionnement (S0) par l'actionneur (41) d'un substrat test (T) sur le support (20) dans une position (P1) de départ en fonction de paramètres (PP1) de départ prédéterminés,
- application des étapes du procédé de détermination d'une position centrée (P2) selon la revendication 1 au substrat test (T),
- détermination (S4) de paramètres (PP2) de centrage correspondant à la position centrée (P2) du substrat test (T), et
- stockage (S5) des paramètres (PP2) de centrage dans l'unité de mémoire (42).

3. Procédé de calibrage selon la revendication précédente, dans lequel l'ensemble des étapes du procédé sont répétées selon un nombre d'itérations donné, les paramètres (PP2) de centrage déterminés à chaque itération étant repris comme paramètres (PP1) de départ de l'itération suivante.

4. Dispositif (100) pour traiter thermiquement des substrats semi-conducteur (10) **caractérisé en ce qu'**il comprend :
- un four (30) avec un support (20) de maintien,
- une unité (60) de mesure destinée à déterminer une épaisseur du substrat (10) en plusieurs points de mesure, et
- des moyens de positionnement (40) comprenant
une unité de mémoire (42) destinée à stocker des paramètres (PP) de positionnement correspondant à des positions d'un substrat sur le support (20),
un actionneur (41) pour positionner un substrat (10) sur le support (20) en fonction de paramètres (PP) de positionnement stockés dans l'unité (42) de mémoire, et
une unité de traitement (50) destinée à déterminer, en fonction d'une position (P1) de départ et de mesures de l'unité de mesure (60), une position centrée (P2) et à déduire de ladite position centrée (P2) des paramètres (PP2) de centrage
l'unité (42) de mémoire étant en outre destinée à stocker les paramètres (PP2) de centrage, de sorte à ce que l'actionneur (41) soit apte à positionner des substrats semi-conducteur (10) sur le support (20) dans la position centrée (P2).
